# EUROPEAN PATENT APPLICATION

(11) **EP 4 841 452 A2**
(43) Date of publication of application: **18.11.2026**
(21) Application number: 26185177.8
(22) Date of filing: 15.06.2026
(51) Int. Cl.: G06F 11/3668

(54) **METHOD AND APPARATUS OF PROCESSING SIMULATION DATA, AND STORAGE MEDIUM**

(30) Priority: 17.09.2025 CN 202511332854
(71) Applicant: Apollo Intelligent Driving Technology (Beijing) Co., Ltd., Haidian District Beijing 100085 (CN)
(72) Inventor: ZHANG, Shuai, Beijing, 100085 (CN)
(74) Representative: Hannke Bittner & Partner mbB Regensburg

(57) **Abstract**

Provided is a method and apparatus, relating to the fields of artificial intelligence, big data, intelligent transportation and autonomous driving. The method includes: obtaining (S101) historical road test data including original data for a same target historical time period uploaded by each data unit of N data units of a road test vehicle; parsing (S102) an i-th channel of original data in the historical road test data to obtain parsed data that matches a preset data format of a data unit of the i-th channel of original data; performing (S103) downsampling processing on each channel of parsed data to obtain initial sampling data corresponding to each channel; adjusting (S104) a data frequency of the initial sampling data corresponding to each channel to obtain target simulation data corresponding to each channel; and sending (S105) the target simulation data corresponding to each channel to an autonomous driving controller.

## Description

### TECHNICAL FIELD

The present disclosure relates to the field of data processing technology, specifically to technical fields of artificial intelligence, big data, intelligent transportation, autonomous driving and the like.

### BACKGROUND

In the field of autonomous driving, a Hardware-in-the-Loop (HIL) simulation test requires a replay test of road test data, and a simulation time period required for the replay test is equal to a road test time period in a real road scenario, that is, the replay test is an equal proportion (i.e., 1:1) simulation test. Therefore, when facing massive road test data, the replay test takes significant time and incurs high time costs, seriously affecting overall efficiency of an autonomous driving simulation test.

### SUMMARY

The present disclosure provides a method and apparatus of processing simulation data, and a storage medium.

According to an aspect of the present disclosure, a method of processing simulation data for autonomous driving is provided, which includes:
obtaining, by a simulation device, historical road test data, where the historical road test data includes original data for a same target historical time period uploaded by each data unit of N data units of a road test vehicle;
parsing an i-th channel of original data in the historical road test data to obtain parsed data that matches a preset data format of a data unit of the i-th channel of original data, i is a positive integer not greater than N;
after determining that all N channels of original data have been parsed, performing downsampling processing on each channel of parsed data to obtain initial sampling data corresponding to each channel;
adjusting a data frequency of the initial sampling data corresponding to each channel to obtain target simulation data corresponding to each channel; and
sending the target simulation data corresponding to each channel to an autonomous driving controller for simulation.

According to another aspect of the present disclosure, a simulation apparatus is provided, which includes:
an obtaining unit configured to obtain historical road test data, where the historical road test data includes original data for a same target historical time period uploaded by each data unit of N data units of a road test vehicle; and
a processing unit configured to: parse an i-th channel of original data in the historical road test data to obtain parsed data that matches a preset data format of a data unit of the i-th channel of original data, after determining that all N channels of original data have been parsed, perform downsampling processing on each channel of parsed data to obtain initial sampling data corresponding to each channel, adjust a data frequency of the initial sampling data corresponding to each channel to obtain target simulation data corresponding to each channel, and send the target simulation data corresponding to each channel to an autonomous driving controller for simulation, i is a positive integer not greater than N.

According to another aspect of the present disclosure, an electronic device is provided, which includes:
at least one processor; and
a memory connected in communication with the at least one processor,
where the memory stores an instruction executable by the at least one processor, and the instruction, when executed by the at least one processor, enables the at least one processor to execute the method of any of embodiments in the present disclosure.

According to another aspect of the present disclosure, a non-transitory computer-readable storage medium storing a computer instruction thereon is provided, where the computer instruction is used to cause a computer to execute the method of any of embodiments in the present disclosure.

According to another aspect of the present disclosure, a computer program product is provided, which includes a computer program, the computer program, when executed by a processor, implements the method of any of embodiments in the present disclosure.

In this way, the solution of the present disclosure can downsample each channel of parsed data obtained by parsing to obtain the initial sampling data corresponding to each channel, adjust the data frequency of the initial sampling data corresponding to each channel, and then use each channel of data after adjusting (the target simulation data corresponding to each channel) for an autonomous driving simulation test. In the above method, downsampling is used to process data to reduce data of data frames of the target simulation data used in a simulation test, thereby increasing data replay speed. In this way, a simulation test cycle is significantly shortened, thereby providing strong support for improving efficiency of the autonomous driving simulation test.

It should be understood that contents described in this part is not intended to identify key or important features of embodiments of the present disclosure, nor is it intended to limit the scope of the present disclosure. Other features of the present disclosure are made easy to be understood by the following description.

### BRIEF DESCRIPTION OF THE DRAWINGS

Accompanying drawings are provided for a better understanding of the present solution and do not constitute a limitation of the present disclosure, in which:
FIG. 1 is a first schematic flow diagram of a method of processing simulation data for autonomous driving according to an embodiment of the present disclosure;
FIG. 2 is a schematic diagram of a synchronous uploading mechanism of road test data according to an embodiment of the present application;
FIG. 3 is a second schematic flow diagram of a method of processing simulation data for autonomous driving according to an embodiment of the present disclosure;
FIG. 4 is an explanatory diagram of time synchronization before downsampling processing according to an embodiment of the present application;
FIG. 5(a) is an explanatory diagram of performing downsampling processing on analysis data according to an embodiment of the present application;
FIG. 5(b) is an explanatory diagram of initial sampling data after downsampling processing according to an embodiment of the present application;
FIG. 6 is an explanatory diagram of modifying time information of an autonomous driving controller according to an embodiment of the present application;
FIG. 7(a) is a third schematic flow diagram of a method of processing simulation data for autonomous driving according to an embodiment of the present disclosure;
FIG. 7(b) is an explanatory diagram of preforming data transmission using a board according to an embodiment of the present application;
FIG. 8 is an explanatory diagram of performing scenario recognition on initial road test data according to an embodiment of the present application;
FIG. 9 is a structural diagram of a simulation apparatus according to another embodiment of the present application; and
FIG. 10 is a block diagram of an electronic device for achieving a method of processing simulation data for autonomous driving according to an embodiment of the present disclosure.

### DETAILED DESCRIPTION

Hereinafter, explanation of exemplary embodiments of the present disclosure will be made in conjunction with the accompanying drawings, which includes various details of the embodiments of the present disclosure to facilitate understanding and should be considered merely exemplary. Therefore, those having ordinary skill in the art should recognize that various changes and modifications may be made to the embodiments described herein without departing from the scope of the present disclosure. Similarly, for clarity and conciseness, descriptions of well-known functions and structures are omitted in the following descriptions.

The term "and/or" herein is merely an associated relationship for describing associated objects, which indicates that there may be three kinds of relationships, for example, A and/or B may mean that there are three cases: A alone, both A and B, and B alone. The term "at least one of..." herein refers to any one of a plurality of items or any combination of at least two of the plurality of items, for example, including at least one of A, B or C may represent any one or more elements selected from a set consisting of A, B, and C. The terms "first" and "second" refer to a plurality of similar technical terms and distinguish them, and do not limit an order thereof or limit there are only two items, for example, a first feature and a second feature refer to two types/two features, the first feature may be one or more and the second feature may also be one or more.

In addition, in order to better illustrate the present disclosure, a number of specific details are given in specific implementations below. Those having skill in the art should understand that the present disclosure may also be implemented without certain specific details. In some examples, methods, means, elements and circuits which are well known to those having skill in the art are not described in detail, so as to highlight the main purpose of the present disclosure.

The following describes relevant technologies of the embodiments of the present disclosure. The following related technologies as optional solutions may be combined with the technical solution of the embodiments of the present disclosure, and they all fall within the protection scope of the embodiments of the present disclosure.

The following provides a detailed explanation of terms that may be involved in the solution of the present disclosure:
Road test data refers to a collection of time-series data collected and synchronously recorded by a vehicle (such as a car, an autonomous vehicle, and the like) driving in a real road environment through its equipped sensors (such as a camera, a LiDAR, a millimeter wave radar, and the like), a controller, a positioning device, and the like. For example, the road test data may specifically include environment perception data, vehicle bus data, positioning data, auxiliary information and the like, which are mainly used for algorithm development, model training, simulation test, performance evaluation, verification and the like of an autonomous driving system, and can also provide a real-world scenario library for a simulation platform.

A replay test is a simulation test technique that mainly inputs the road test data (such as sensor data, positioning data, and the like) collected from real roads into a simulation environment, in order to accurately "reproduce" a driving scenario of a vehicle at that time in the simulation environment, and test and verify an autonomous driving algorithm in the "reproduced" driving scenario.

Hardware-in-the-Loop (HIL) is an advanced technology used for development and test of a complex system controller, a core of which lies in combining an actual hardware controller with the simulation environment to achieve efficient verification of system performance.

In the field of autonomous driving, a HIL simulation test requires performing the replay test on the road test data. However, test time required by a current replay test is the same as time of the road test data, that is, it is a 1:1 simulation test. For example, for the same section of road test data, a road test time period of real roads required by a test in a real road scenario is 20 hours, and a simulation test time period required by the simulation test in a HIL simulation test scenario is also 20 hours. Moreover, there is no acceleration manner available, which reduces efficiency of the simulation test and thus affects validation efficiency of the autonomous driving algorithm.

Based on this, the solution of the present disclosure provides a method of processing simulation data for autonomous driving, which can accelerate the simulation test and effectively improve the efficiency of the simulation test, for example, effectively improving efficiency of a scenario replay simulation test, thereby providing strong support for improving the verification efficiency of the autonomous driving algorithm. Specifically, the solution of the present disclosure, after completing parsing of obtained historical roading test data (including original data of N channels) and obtaining parsed data of the N channel, first performs downsampling processing on the parsed data of each channel, then adjusts a data frequency corresponding to the parsed data of each channel after downsampling processing, to obtain new data that can be used for the simulation test (i.e., target simulation data corresponding to each channel), and finally injects the obtained new data of each channel into an autonomous driving controller for the simulation test. In this way, a downsampling technology is fully utilized to accelerate replay speed, and thus the simulation test time period is significantly shortened, thereby improving overall efficiency of an autonomous driving simulation test.

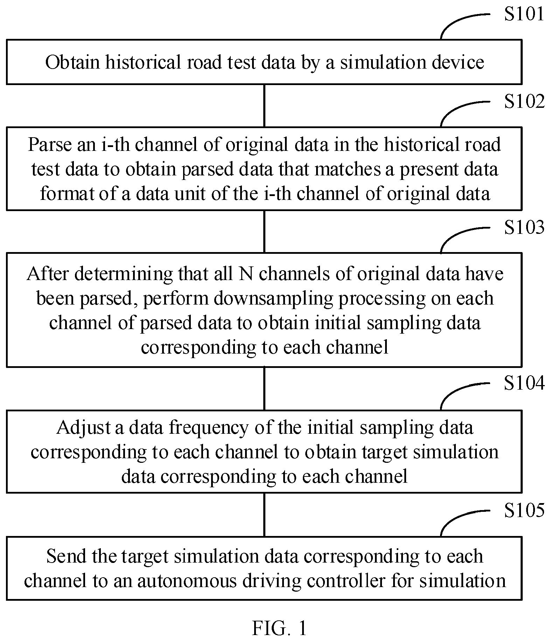

Specifically, FIG. 1 is a first schematic flow diagram of a method of processing simulation data for autonomous driving according to an embodiment of the present disclosure. The method is optionally applied in an electronic device, such as a personal computer, a server, a server cluster, and other electronic devices.

Furthermore, the method at least includes at least some of the following contents. As shown in FIG. 1, the method includes following steps.

In step S101, historical road test data is obtained by a simulation device.

Here, the historical road test includes original data for the same target historical time period uploaded by each data unit of N data units of a road test vehicle.

Furthermore, in an example, data acquisition dimensions of different data units are different. In other words, original data uploaded by different data units can represent driving information of the road test vehicle from different dimensions, so as to achieve multi-dimensional representation.

Here, it should be noted that an acquisition frequency of each data unit may be the same or different, which is not limited in the solution of the present disclosure.

Furthermore, in an example, each channel of original data includes a plurality of data frames arranged in a chronological order. In other words, each channel of original data includes a continuous sequence of a plurality of frames, for example, each frame corresponds to sampling of the data unit at a specific time point.

Furthermore, a number of data frames included in different channels of original data may be the same or different, which is not limited in the solution of the present disclosure.

In step S102, an i-th (i is a positive integer not greater than N) channel of original data in the historical road test data is parsed to obtain parsed data that matches a present data format of a data unit of the i-th channel of original data.

In step S103, after determining that all N channels of original data have been parsed, downsampling processing is performed on each channel of parsed data to obtain initial sampling data corresponding to each channel.

Here, in an example, a downsampling ratio, also known as a frame extraction ratio, for different parsed data may be the same or different, which is not limited in the solution of the present disclosure.

In step S104, a data frequency of the initial sampling data corresponding to each channel is adjusted to obtain target simulation data corresponding to each channel.

Herein, a number of data frames included in an i-th channel of target simulation data is smaller than a number of data frames included in the i-th channel of original data, in this way, a data amount is effectively reduced, thereby providing strong support for improving a speed of the simulation test in the future.

In step S105, the target simulation data corresponding to each channel is sent to an autonomous driving controller for simulation.

In this way, the solution of the present disclosure can downsample each channel of parsed data obtained by parsing to obtain the initial sampling data corresponding to each channel, adjust the data frequency of the initial sampling data corresponding to each channel, and then use each channel of data after adjusting (the target simulation data corresponding to each channel) for the autonomous driving simulation test. In the above method, downsampling is used to process data to reduce data of data frames of the target simulation data used in the simulation test, thereby increasing data replay speed. In this way, a simulation test cycle is significantly shortened, thereby providing strong support for improving efficiency of the autonomous driving simulation test.

Moreover, the solution of the present disclosure can reduce data amount of the simulation data used in the simulation test by optimizing the historical road test data. Therefore, compared to an existing equal proportion replay test solution, the solution of the present disclosure achieves acceleration of the replay test while effectively reducing computational resources occupied by a simulation test process.

In a specific example, the road test vehicle is equipped with various types of data units, including but not limited to a camera, a millimeter wave radar, a lidar, a controller area network (CAN) bus (such as for collecting vehicle chassis data), a global navigation satellite system (GNSS) receiver and the like.

It may be understood that the solution of the present disclosure does not limit types and a number of the data units, which may be set according to actual road test needs.

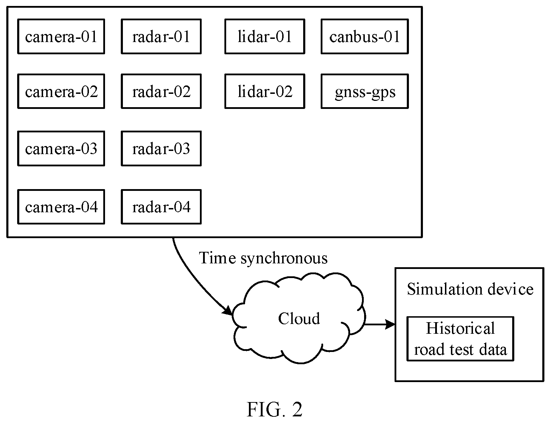

Furthermore, for example, as shown in FIG. 2, a synchronous uploading mechanism of the solution of the present disclosure is explained by taking a road test vehicle including 12 data units as an example. Here, the 12 data units may be 4 cameras, 4 millimeter wave radars, 2 laser radars, 1 CAN bus and 1 GNSS receiver. The four cameras may be respectively referred to as camera-01, camera-02, camera-03, and camera-04. The 4 millimeter wave radars may be respectively referred to as radar-01, radar-02, radar-03, and radar-04. The 2 lidars may be respectively referred to as lidar 01 and lidar 02. The CAN bus is referred to as canbus-01, and the GNSS receiver may be referred to as gnss-gps.

Here, in an example, after obtaining 12 channels of original data by using the 12 data units as described above, the road test vehicle uses a hardware timestamp mechanism to mark each frame of each channel of original data with a unified and accurate timestamp, and uploads these channels of original data with the timestamps to a cloud. The cloud completes time synchronization alignment of a plurality of channels of original data based on the timestamps.

For example, in a scenario of reporting the road test data, the GNSS receiver may be used as a main clock source, and through a clock synchronization mechanism such as a Precision Time Protocol (PTP) or Generalized Precision Time Protocol (GPTP), distributed clock synchronization may be performed across the plurality of data units to ensure microsecond level synchronization between a local clock of each data unit and the main clock source. Furthermore, each data unit is marked each data frame with an accurate PTP timestamp at the physical layer when collecting each data frame. Furthermore, these channels of original data with the timestamps are streamed in real-time or near real-time to the cloud through a vehicle network. The cloud aligns and reassembles each channel of data at the same time point based on the timestamp in each of data streams, rather than an order in which the data streams arrive at the cloud, in order to obtain each channel of original data in the same historical time period and reproduce a complete historical scenario.

In a specific example, transmission resources required for occupation by the original data uploaded by each data unit are less than transmission resources required for occupation by the parsed data corresponding to each data unit.

It should be noted that in order to reduce resources occupied by data transmission, the original data uploaded by each data unit may be specifically encoded data. For example, the original data uploaded by each data unit is data in a binary format. For example, compared to directly transmitting data without encoding, it can effectively reduce the occupied transmission resources, improve transmission efficiency, and also reduce data upload costs.

It may be understood that since the uploaded data is the encoded data, before the simulation test, it is necessary to parse the encoded data, that is, the uploaded original data, in order to facilitate the subsequent simulation test.

Furthermore, in a specific example, the following manner may be used to parse the i-th channel of original data. Specifically, parsing the i-th channel of original data in the historical road test data as described above (for example, the step S102) may specifically include:
parsing the i-th channel of original data by using a data format protocol of the data unit corresponding to the i-th channel.

That is, the i-th channel of original data is parsed by using the data format protocol of the data unit corresponding to the i-th channel of original data, in this way, structured data acquired by each data unit is restored through parsing, and a real scenario where the road test vehicle is located is restored, thereby providing a high-quality data foundation for the subsequent simulation test, such as scenario reconstruction and algorithm backtest.

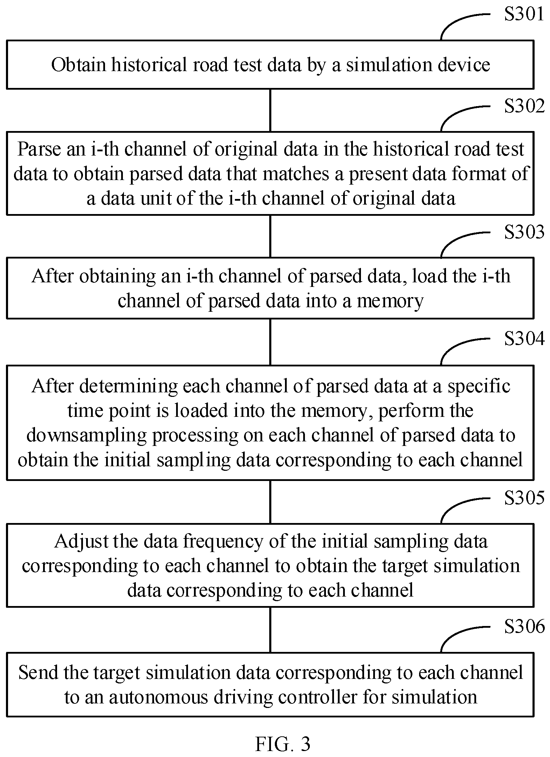

FIG. 3 is a second schematic flow diagram of a method of processing simulation data for autonomous driving according to an embodiment of the present disclosure. The method is optionally applied in an electronic device, such as a personal computer, a server, a server cluster, and other electronic devices. It may be understood that relevant contents of the methods shown in FIGS. 1 and 2 above may also be applied to this example, and the related contents will not be repeated in this example.

Furthermore, the method at least includes at least some of the following contents. As shown in FIG. 3, the method includes following steps.

In step S301, the historical road test data is obtained by the simulation device.

Here, the historical road test includes the original data for the same target historical time period uploaded by each data unit of the N data units of the road test vehicle.

Here, relevant explanations related to the data units and the original data may refer to the above descriptions, which will not be repeated here.

In step S302, the i-th (i is a positive integer not greater than N) channel of original data in the historical road test data is parsed to obtain the parsed data that matches the present data format of the data unit of the i-th channel of original data.

In step S303, after obtaining an i-th channel of parsed data, the i-th channel of parsed data is loaded into a memory.

Here, it should be noted that, due to differences in times costed by parsing each channel of original data, in order to maximize processing efficiency and quickly obtain the target simulation data, the solution of the present disclosure adopts an asynchronous parsing and loading strategy in which once any channel of original data is parsed, its result may be immediately loaded into a cache area of the memory without waiting for parsing of other channels of data. In this way, unnecessary waiting delays are eliminated, and pipeline processing is achieved, thereby improving response speed.

In step S304, after determining each channel of parsed data at a specific time point is loaded into the memory, the downsampling processing is performed on each channel of parsed data to obtain the initial sampling data corresponding to each channel.

It should be noted that, due to time required for "first parsing and then loading" each channel of original data is different, in order to ensure time synchronization among all channels, downsampling processing may be performed after determining that each channel of parsed data at the specific time point has been loaded. In other words, after time synchronization among all channels, downsampling processing may be performed, thereby laying a foundation for normal processing of the subsequent simulation test.

Furthermore, in an example, the specified time point is related to the target historical time period. For example, if the specified time point is any time point in the target historical time period. For example, the target historical time period is [t0, t1], the specified time point is any time point in [t0, t1]. Alternatively, in another example, the specified time point is specifically a starting time point of the target historical time period, which is the time point t0.

In this way, it ensures that each channel of parsed data used for subsequent processing are strictly aligned in a time dimension, thereby providing strong support for improving accuracy and reliability of simulation test results.

In step S305, the data frequency of the initial sampling data corresponding to each channel is adjusted to obtain the target simulation data corresponding to each channel.

In step S306, the target simulation data corresponding to each channel is sent to the autonomous driving controller for simulation.

In this way, the solution of the present disclosure ensures strict temporal alignment of all channels data at the beginning of the downsampling processing by waiting for all data to be loaded at the same time point, thereby achieving time synchronization in a data processing stage and effectively avoiding timing errors caused by differences in data loading timing. Moreover, the solution of the present disclosure can wait for all data to be loaded at the same time point before performing the downsampling processing, effectively avoiding noise and uncertainty introduced by time asynchrony, in this way, the accuracy and reliability of the simulation test results are significantly improved while accelerating the data replay speed in the subsequent simulation test.

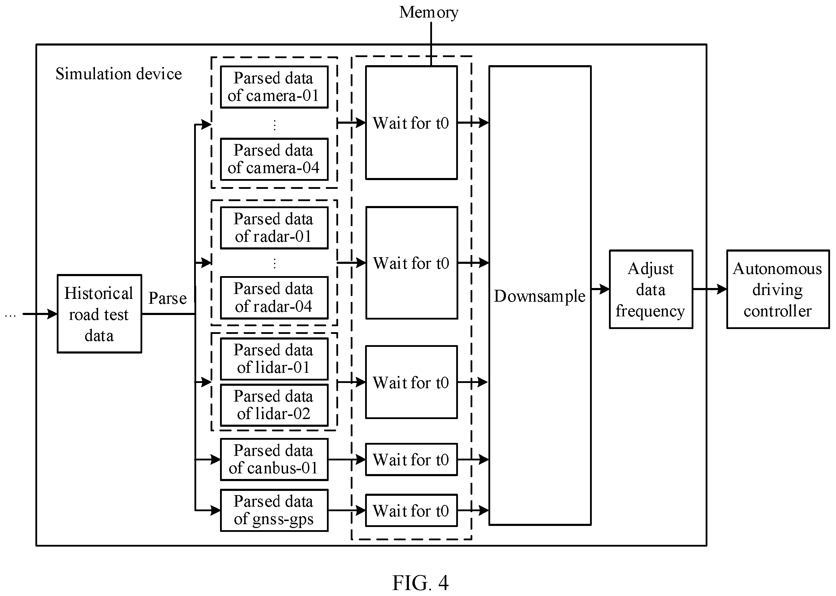

Furthermore, FIG. 4 is an explanatory diagram of time synchronization before downsampling processing according to an embodiment of the present application. As shown in FIG. 4, after obtaining the historical test data uploaded in FIG. 2, the original data corresponding to each data unit is first parsed, and after obtaining each channel of parsed data, it is loaded into the memory, for example, after obtaining the parsed data corresponding to camera-01, it is loaded into the memory, similarly, after obtaining the parsed data corresponding to other data units (such as any data unit of camera-02 to camera-04, radar-01 to radar-04, lidar-01 and lidar-02, canbus-01 and gnss-gps), it is loaded into the memory. Furthermore, after waiting for all channels of parsing data to be loaded into the memory at the time point t0, the downsampling processing is started on each channel of parsing data to obtain the initial sampling data corresponding to each channel. Furthermore, the data frequency of the initial sampling data corresponding to each channel is adjusted to obtain the target simulation data corresponding to each channel. Finally, the target simulation data corresponding to each channel is injected into the autonomous driving controller for the simulation test. In this way, by waiting for all data to be loaded at the same time point before performing the downsampling processing, the noise and uncertainty introduced by time asynchrony are effectively avoided, and the data replay speed in the subsequent simulation tests is accelerated, meanwhile, the accuracy and reliability of the simulation test results are significantly improved.

Furthermore, in a specific example, the following manner is adopted to obtain the initial sampling data corresponding to each channel. Specifically, performing the downsampling processing on each channel of parsed data to obtain the initial sampling data corresponding to each channel may specifically include:
determining a downsampling ratio corresponding to each channel; and
performing the downsampling processing on each channel of parsed data based on the downsampling ratio corresponding to each channel (for example, retaining some data frames at equal intervals and discarding remaining data frames) to obtain the initial sampling data corresponding to each channel.

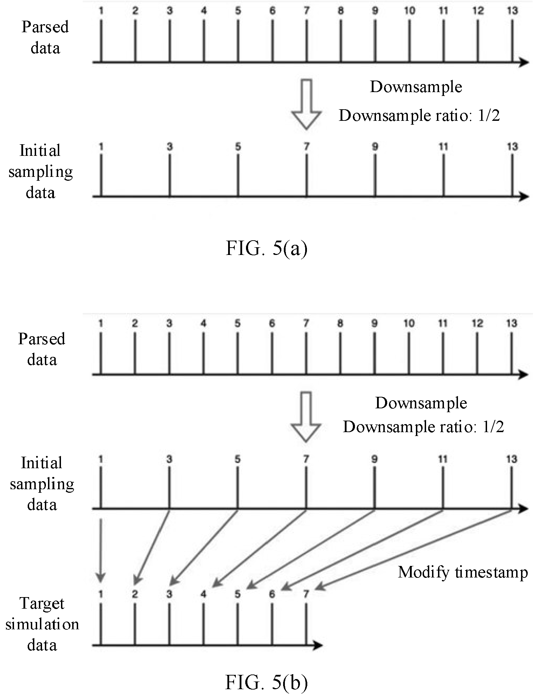

For example, as shown in FIG. 5(a), taking the parsed data including 13 data frames (that is the original data including 13 continuous data frames) as an example, at this time, if the downsampling ratio is 1/2, the downsampling processing may be performed on the parsed data including the 13 data frames according to the downsampling ratio of 1/2 to obtain the initial sampling data including 7 data frames.

Here, it should be noted that the downsampling ratio in the above example is only an example. In practical applications, for the same channel of parsed data, the downsampling ratio used may also be specific to another ratio such as 1/3, 1/4, or the like, which is not limited in the solution of the present disclosure. For example, in practical applications, the downsampling ratio may be set according to actual application needs.

Furthermore, downsampling ratios corresponding to different channels be the same or different, which is not limited in the solution of the present disclosure.

In this way, the solution of the present disclosure can utilize the downsampling processing to reduce the data amount of data used in the subsequent simulation test, thereby improving efficiency of data processing, storage, and transmission, in this way, it facilitates replay acceleration in the subsequent simulation test, thereby shortening the simulation test cycle and significantly improving the overall efficiency of the autonomous driving simulation test.

Furthermore, in a specific example, the downsampling ratio corresponding to each channel may be determined based on at least one of a data acquisition frequency of a data unit of the current channel, a scenario characteristic of the historical road test data, or a degree of influence of data uploaded by the data unit of the current channel on an autonomous driving decision.

For example, in an example, the downsampling ratio in the solution of the present disclosure may be determined based on the scenario characteristic of the historical road test data. For example, for a scenario that is not of interest to the simulation test, such as a parking lot scenario or a scenario of waiting for traffic lights, a larger downsampling ratio may be set, such as 1/2, to accelerate replay of the scenario that is not of interest to the simulation test, thereby minimizing an impact of downsampling on a simulation effect while improving simulation test efficiency.

Alternatively, in another example, the downsampling ratio corresponding to the current channel may be determined based on the data acquisition frequency of the data unit corresponding to the current channel. For example, if the data acquisition frequency of the data unit corresponding to the current channel is higher, it indicates that there are more data frames in the parsed data of the current channel. In this case, a larger downsampling ratio may be set to reduce the data amount for the simulation test.

Alternatively, in another example, the downsampling ratio corresponding to the current channel may also be determined based on the degree of influence of the data uploaded by the data unit corresponding to the current channel on the autonomous driving decision. For example, if the data uploaded by the data unit corresponding to the current channel has a higher degree of influence on the autonomous driving decision, a smaller downsampling ratio may be set, or if the data uploaded by the data unit corresponding to the current channel has a lower degree of influence on the autonomous driving decision, a larger downsampling ratio may be set, in order to minimize the impact of downsampling on the simulation effect to the greatest extent possible.

Alternatively, in another example, the downsampling ratio corresponding to the current channel may be determined based on any two or three of the data acquisition frequency of the data unit of the current channel, the scenario characteristic of the historical road test data, and the degree of influence of the data uploaded by the data unit of the current channel on the autonomous driving decision.

It should be noted that the determination of the downsampling ratio is not limited to the above manners, and may also be determined based on actual needs or empirical values, which is not limited in the solution of the present disclosure.

In this way, the solution of the present disclosure provides a specific scheme for determining the downsampling ratio corresponding to each channel, for example, the downsampling ratio corresponding to each channel may be determined from three aspects: the data acquisition frequency of the data unit, importance of a scenario, and the impact of the data on the autonomous driving decision. In this way, redundant data in the parsed data of each channel may be removed, thereby providing strong support for accelerating replay test and improving test efficiency of the autonomous driving simulation test in the future.

Furthermore, in a specific example, adjusting the data frequency of the initial sampling data corresponding to each channel to obtain the target simulation data corresponding to each channel as described above (for example, the step S305 or the step S104) may specifically include:
adjusting the data frequency of the initial sampling data corresponding to each channel by a manner of modifying a timestamp, to make a frame rate in unit time of the initial sampling data corresponding to each channel match with a frame rate in unit time of each channel of original data, for example, make the frame rate in unit time of the initial sampling data corresponding to each channel be consistent with the frame rate in unit time of each channel of original data, in other words, to keep the data frequency consistent with a data frequency before downsampling. The data frequency of any data stream is a time interval between any adjacent data frames in that data stream.

For example, as shown in FIG. 5(b), after completing the downsampling and obtaining the initial sampling data by using the manner shown in FIG. 5(a), timestamps of the second frame to the last frame are modified. For example, for the original data with a data frequency of T, a timestamp of the n-th (n is a natural number greater than 2) data frame in the initial sampling data may be modified to t0+(n-1) T to obtain the target simulation data. At this time, a data frequency of the target simulation data is the same as the data frequency before the downsampling (for example, both are the data frequency of T), and the frame rates of both are also the same. In this example, if the simulation test is conducted based on the target simulation data, a double-speed replay test may be achieved, thereby doubling the test efficiency.

It should be noted that the solution of the present disclosure performs the downsampling processing on each channel of parsing data, which results in a mismatch between the frame rate in unit time of each channel of parsed data (i.e., the initial sampling data corresponding to each channel) after the downsampling and the frame rate in unit time of each channel of parsed data before the downsampling, for example, inconformity between the frame rate in unit time of each channel of parsed data after the downsampling and the frame rate in unit time of each channel of parsed data before the downsampling. At this time, in order to ensure smooth progress of the simulation test or to balance an existing simulation test logic and improve the simulation test efficiency, the solution of the present disclosure may also adjust the data frequency of the initial sampling data corresponding to each channel by adjusting the timestamp of each data frame to be consistent with the original data frequency. For example, for the initial sampling data, by modifying the timestamps of some of its frames, the data frequency of the initial sampling data is adjusted to be consistent with the data frequency before the downsampling processing.

It should be noted that the frame rate of the original data involved in the solution of the present disclosure is a predetermined fixed value. For example, in practical applications, the frame rate of the original data is related to a hardware structure of its corresponding data unit, or it may also be related to a bandwidth during data transmission. The solution of the present disclosure does not impose specific limitations on the manner of determining the frame rate of the original data.

In this way, the solution of the present disclosure makes the frame rates in unit time of the data before and after the downsampling be matched with each other by modifying the timestamps of some frames in the initial sampling data, in this way, a problem of timestamp jumps caused by the downsampling processing on different channels of parsed data is effectively avoided, meanwhile, it effectively reduces the data amount of the data used in the simulation test, accelerates the replay test, and improves the simulation test efficiency.

Moreover, compared to a manner of directly increasing a play speed, the solution of the present disclosure only reconstructs the data of each data unit at a hardware level. In the rsubsequen replay test, it accelerates the replay test while reducing computational resources required for the simulation test, thereby improving test efficiency of the autonomous driving test.

Furthermore, in a specific example, in order to ensure that the test scenario of the autonomous driving controller is synchronized with the historical road test data in time, the solution of the present disclosure may also modify time information of the autonomous driving controller based on the historical road test data. For example, in an example, the simulation device generates a time modification request based on the target historical time period of the historical road test data, and sends the time modification request to the autonomous driving controller, where the time modification request is used to request the autonomous driving controller to modify current time information to a historical time point that matches with the target historical time period, so as to ensure that the test scenario of the autonomous driving controller is synchronized with the historical road test data in time.

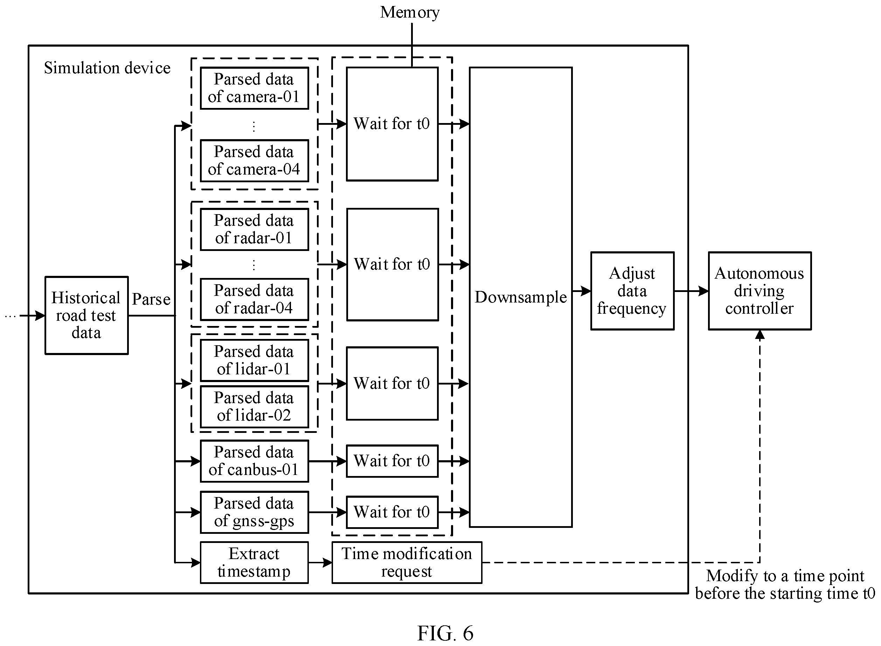

For example, taking the scenario shown in FIG. 4 as an example, as shown in FIG. 6, the simulation device may extract timestamp information from the parsed data, determine the target historical time period based on the extracted timestamp information, and then generate the time modification request based on the target historical time period (e.g., the target historical time period is t0~t1), for example, the time modification request carries the start time point t0. Furthermore, the simulation device sends the time modification request to the autonomous driving controller, so that the autonomous driving controller modifies its current time information based on the start time point t0 carried in the time modification request, for example, modifies the current time information to a time point before the start time point t0, in this way, it is ensured that a simulation test scenario of the autonomous driving controller is consistent with a real historical scenario, thereby improving the accuracy and reliability of the test.

In this way, the solution of the present disclosure may modify the time information of the autonomous driving controller to a historical time point that matches with the target historical time period, in order to reconstruct the corresponding historical scenario in the simulation environment, thereby simulating a complete driving environment of the target historical time period, which facilitates the autonomous driving controller to make decisions and responses based on accurately reproduced historical spatiotemporal information, effectively avoiding test distortion caused by spatiotemporal deviations between the test environment and the real historical scenario, and significantly improving the accuracy and reliability of the simulation test.

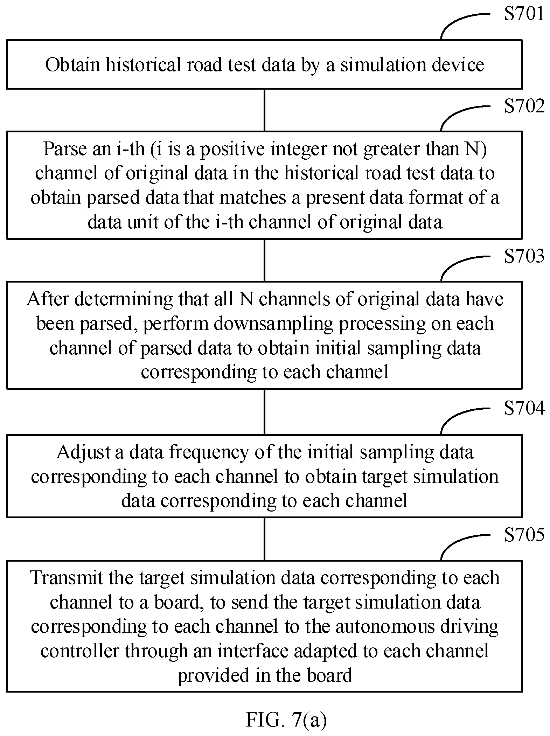

FIG. 7 (a) is a third schematic flow diagram of a method of processing simulation data for autonomous driving according to an embodiment of the present disclosure. The method is optionally applied in an electronic device, such as a personal computer, a server, a server cluster, and other electronic devices. It may be understood that relevant contents of the methods shown in FIGS. 1 to 6 above may also be applied to this example, and the related contents will not be repeated in this example.

Furthermore, the method at least includes at least some of the following contents. As shown in FIG. 7(a), the method includes following steps.

In step S701, the historical road test data is obtained by the simulation device.

Here, the historical road test includes the original data for the same target historical time period uploaded by each data unit of the N data units of the road test vehicle.

Here, relevant explanations related to the data units and the original data may refer to the above descriptions, which will not be repeated here.

In step S702, the i-th (i is a positive integer not greater than N) channel of original data in the historical road test data is parsed to obtain the parsed data that matches the present data format of the data unit of the i-th channel of original data.

Here, relevant explanations related to parsing the i-th channel of original data may refer to the above descriptions, which will not be repeated here.

In step S703, after determining that all N channels of original data have been parsed, the downsampling processing is performed on each channel of parsed data to obtain the initial sampling data corresponding to each channel.

Here, relevant explanations related to performing the downsampling processing on each channel of parsed data may refer to the above descriptions, which will not be repeated here.

In step S704, the data frequency of the initial sampling data corresponding to each channel is adjusted to obtain the target simulation data corresponding to each channel.

In step S705, the target simulation data corresponding to each channel is output to a board, to send the target simulation data corresponding to each channel to the autonomous driving controller through an interface adapted to each channel provided in the board.

Here, the simulation device is provided with the board, furthermore, in an example, the board is further provided with the interface adapted to each channel.

For example, in an example, the board may be a message (MSG) to real physical signal board.

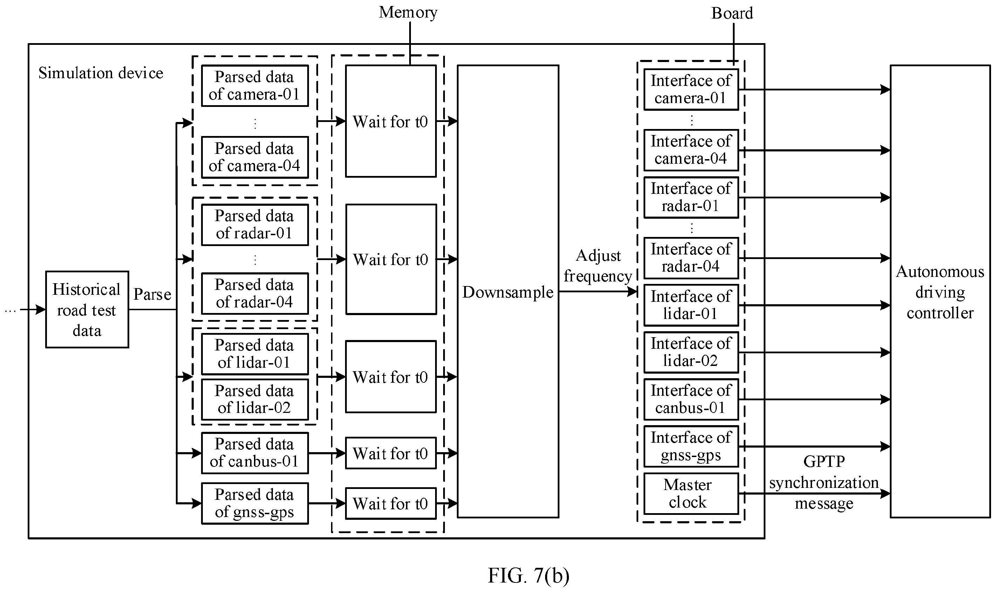

For example, still taking the scenario shown in FIG. 4 as an example, as shown in FIG. 7(b), the simulation device injects the target simulation data corresponding to each channel into the board of the simulation device, after adjusting the data frequency of the initial sampling data corresponding to each channel and obtaining the target simulation data corresponding to each channel by reassembling. For example, in an example, after obtaining the target simulation data, the simulation device may transfer the target simulation data from the memory to a hard disk. At this time, the target simulation data stored in the hard disk may be injected into the board to convert each channel of target simulation data into a physical signal, and the physical signal corresponding to channel is sent to the autonomous driving controller through the interface adapted to each channel provided in the board. In this way stability of data transmission is ensured.

In this way, the solution of the present disclosure utilizes the interfaces adapted to each channel provided in the board to send multi-source data (i.e. the target simulation data corresponding to each channel) to the autonomous driving controller, which achieves efficient transmission of different types of data (such as cameras, radars, CAN buses, and the like), thereby ensuring perception and decision-making capabilities of the simulation test in a complex environment. Moreover, by utilizing interface adaptation, not only the stability of data transmission has been improved, but compatibility and scalability of a system have also been enhanced, thereby providing a reliable data foundation for validation and optimization of the autonomous driving algorithm in the subsequent replay test.

Furthermore, in a specific example, the board is further provided with a master clock, the method further includes:
periodically sending a time synchronization message, for example, a Generalized Precision Time Protocol (GPTP) synchronization message, to the autonomous driving controller through the master clock.

Here, the time synchronization message, for example, the GPTP synchronization message, carries timestamp information of the master clock, so that the autonomous driving controller may perform time synchronization processing on the received a plurality of channels of target simulation data based on the timestamp information.

That is, in an example, as shown in FIG. 7 (b), the timestamp information of the master clock carried by the GPTP synchronization message sent by the master clock in the board is used to calibrate an internal clock of the driving controller, so that the autonomous driving controller can align the target simulation data corresponding to each channel again, when receiving each channel of target simulation data sent by the board, in this way, it facilitates perception fusion and decision planning to run in a consistent time background in the subsequent replay test.

In this way, the solution of the present disclosure provides a time alignment scheme that enables the autonomous driving controller to perform the time synchronization processing on received asynchronous multi-source simulation data based on a unified time reference, in this way, it effectively improves robustness and reliability of subsequent perception processing. Moreover, by strictly aligning the simulation data with the autonomous driving controller in time, historical events in the simulation data (such as vehicle merging, pedestrian crossing, and the like) may be accurately reproduced, thereby providing strong support for subsequent decision planning and algorithm verification.

Furthermore, in a specific example, the solution of the present disclosure provides a manner of obtaining the historical road test data, that is, before obtaining the historical road test data by the simulation device (For example, step S701, or step S301, or step S101), it further includes:
obtaining original road test data, here, the original road test data includes the original data for the same first historical time period uploaded by each data unit of the N data units, and the first historical time period includes the target historical time period; and
performing scenario recognition on the original road test data to identify the historical road test data that satisfies a preset scenario requirement, for example, identify the historical road test data corresponding to a preset scenario.

Here, the preset scenario may be determined based on actual test requirements, which is not limited in the solution of the present disclosure.

It should be noted that in order to improve test efficiency of the scenario replay simulation test, the simulation device may further perform the scenario recognition on the uploaded road test data (i.e. the original road test data) to identify the road test data on which accelerated replay can be performed from the original road test data. For the road test data on which the accelerated replay cannot be performed (such as a key scenario in an autonomous driving scenario), the replay test may be conducted in a 1:1 ratio. In this way, while ensuring the simulation effect, the test efficiency of the simulation test is effectively improved and the simulation test cycle is shortened.

Here, in an example, scenarios where the accelerated replay can be performed include but are not limited to at least one of a scenario of waiting for traffic lights, a scenario of turning around, or a scenario of waiting for passengers to upload, and the like.

Furthermore, in an example, in order to further improve the test efficiency, data unrelated to the autonomous driving decision, for example, the parking lot scenario, that is a scenario where the road test vehicle is parked in the parking lot for a long time, may be filtered. For example, data in the parking lot scenario is deleted from the original road test data, which reduces resources occupied by the simulation test and significantly improves simulation test efficiency of entire original road test data.

In this way, the solution of the present disclosure can identify the road test data that requires the accelerated recovery from the original road test data, that is, identify the historical road test data that satisfies the preset scenario requirement. Therefore, in the subsequent replay test, compared with a 1:1 equal proportional replay solution, the solution of the present disclosure may reduce the resources occupied by the simulation test, significantly shorten the simulation test cycle, improve the efficiency of the simulation test, and provide strong support for improving the overall efficiency of the autonomous driving simulation test.

Furthermore, in a specific example, performing the scenario recognition on the original road test data to identify the historical road test data that satisfies the preset scenario requirement may specifically include:
performing the scenario recognition on the original road test data to identify a time period where a preset scenario is located; and
extracting data of the time period where the preset scenario is located from each channel of original data for the same first historical time period included in the original road test data, to obtain the historical road test data, where the target historical time period is the time period where the preset scenario is located.

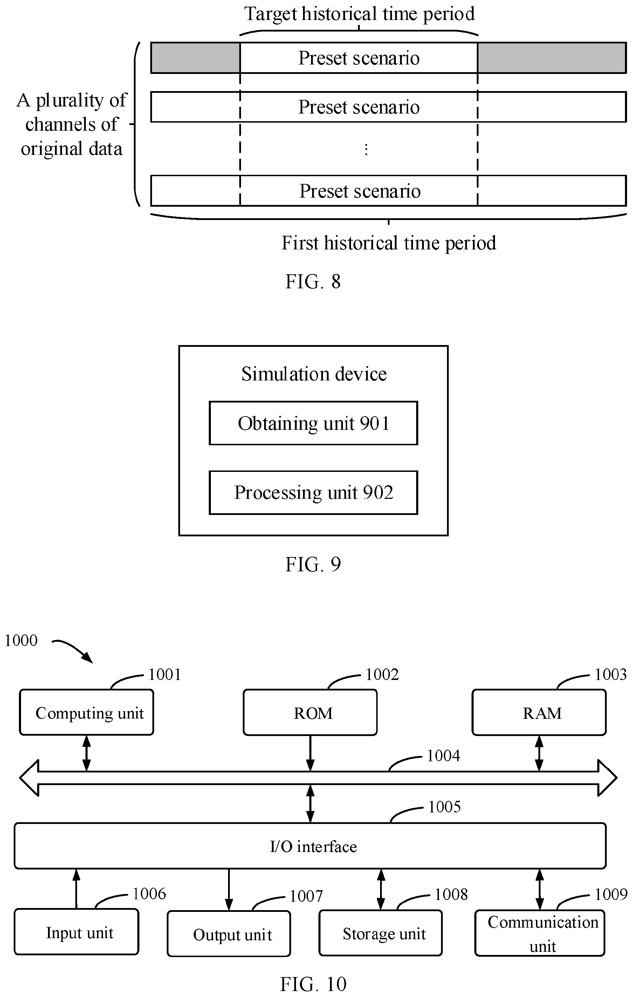

For example, as shown in FIG. 8, in the process of performing the scenario recognition on the original road test data, a channel of original data that is easy to perform the scenario recognition may first be determined from a plurality of channels of original data included in the original road test data, for example, a channel of original data corresponding to a camera (i.e., the original data shown in the gray part of the figure) is determined, and then the scenario recognition is performed on the determined original data of the camera, such as slicing a video stream of the camera and performing speed recognition to identify existence of the preset scenario where the accelerated replay can be performed, and then the time period where the preset scenario is located (i.e., the target historical time period) identified, finally, each channel of data corresponding to the target historical time period is extracted from each channel of original data for the same first historical time period, as the historical road test data.

In this way, the solution of the present disclosure can utilize the determined time period where the preset scenario is located to determine the historical road test data on which the accelerated replay can be performed from the original road test data. Therefore, in the subsequent replay test, while effectively ensuring the simulation effect, the data replay speed is improved, and the simulation test cycle is significantly shortened, thereby providing strong support for improving the overall efficiency of the automatic driving simulation test.

It should be noted that the solution of the present disclosure is mainly applied in the field of autonomous driving simulation test, especially in a scenario of a replay test of landing data in a HIL test. In this scenario, the use of the solution of the present disclosure may accelerate the replay test, effectively improving the simulation speed of scenarios that are not a focus of the simulation test (such as waiting for traffic lights, driving at a constant speed in a straight line, and the like), while not bringing additional load to an algorithm side (because for an algorithm layer, since a frequency of reception has not changed, an overhead of a CPU, GPU or the like will not increase, thus not affecting performance of the autonomous driving algorithm). In this way, it is convenient for the autonomous driving algorithm to focus on a typical scenario, thereby improving the overall efficiency of the autonomous driving simulation test.

The solution of the present disclosure provides a simulation device, as shown in FIG. 9, which includes following units.

An obtaining unit 901 is configured to obtain historical road test data, where the historical road test data includes original data for a same target historical time period uploaded by each data unit of N data units of a road test vehicle.

A processing unit 902 is configured to: parse an i-th channel of original data in the historical road test data to obtain parsed data that matches a preset data format of a data unit of the i-th channel of original data, after determining that all N channels of original data have been parsed, perform downsampling processing on each channel of parsed data to obtain initial sampling data corresponding to each channel, adjust a data frequency of the initial sampling data corresponding to each channel to obtain target simulation data corresponding to each channel, and send the target simulation data corresponding to each channel to an autonomous driving controller for simulation, i is a positive integer not greater than N.

In a specific example of the solution of the present disclosure, the processing unit is further configured to:
after obtaining an i-th channel of parsed data, load the i-th channel of parsed data into a memory; and
after determining each channel of parsed data at a specific time point is loaded to the memory, perform the downsampling processing on each channel of parsed data to obtain the initial sampling data corresponding to each channel.

In a specific example of the solution of the present disclosure, the specified time point is related to the target historical time period.

In a specific example of the solution of the present disclosure, the specified time point is a starting time point of the target historical time period.

In a specific example of the solution of the present disclosure, the processing unit is specifically configured to:
determine a downsampling ratio corresponding to each channel; and
perform the downsampling processing on each channel of parsed data based on the downsampling ratio corresponding to each channel to obtain the initial sampling data corresponding to each channel.

In a specific example of the solution of the present disclosure, the downsampling ratio corresponding to each channel is determined based on at least one of:
a data acquisition frequency of a data unit of a current channel;
a scenario characteristic of the historical road test data; or
a degree of influence of data uploaded by the data unit of the current channel on an autonomous driving decision.

In a specific example of the solution of the present disclosure, the processing unit is specifically configured to:
adjust the data frequency of the initial sampling data corresponding to each channel by a manner of modifying a timestamp, to make a frame rate in unit time of the initial sampling data corresponding to each channel match with a frame rate in unit time of the original data corresponding to each channel.

In a specific example of the solution of the present disclosure, transmission resources required for occupation by the original data uploaded by each data unit are less than transmission resources required for occupation by the parsed data corresponding to each data unit.

In a specific example of the solution of the present disclosure, the original data uploaded by each data unit is data in a binary format.

In a specific example of the solution of the present disclosure, the processing unit is specifically configured to:
parse the i-th channel of original data by using a data format protocol of the data unit corresponding to the i-th channel.

In a specific example of the solution of the present disclosure, the processing unit is further configured to:
generate a time modification request based on the target historical time period of the historical road test data; and
send the time modification request to the autonomous driving controller, where the time modification request is configured to request the autonomous driving controller to modify current time information to a historical time point that matches with the target historical time period.

In a specific example of the solution of the present disclosure, the simulation device is provided with a board, and the board is provided with an interface adapted to each channel, and
where the processing unit is specifically configured to:
transmit the target simulation data corresponding to each channel to the board, to send the target simulation data corresponding to each channel to the autonomous driving controller through the interface adapted to each channel provided in the board.

In a specific example of the solution of the present disclosure, the board is further provided with a master clock, where the processing unit is further configured to:
periodically send a time synchronization message to the autonomous driving controller through the master clock, where the time synchronization message carries timestamp information of the master clock, so that the autonomous driving controller is able to perform time synchronization processing on a plurality of channels of target simulation data that is received based on the timestamp information.

In a specific example of the solution of the present disclosure, the obtaining unit is further configured to:
obtain original road test data, the original road test data includes original data for a same first historical time period uploaded by each data unit of the N data units, and the first historical time period includes the target historical time period; and
perform scenario recognition on the original road test data to identify the historical road test data that satisfies a preset scenario requirement.

In a specific example of the solution of the present disclosure, the processing unit is specifically configured to:
perform the scenario recognition on the original road test data to identify a time period where a preset scenario is located; and
extract data of the time period where the preset scenario is located from each channel of original data for the same first historical time period included in the original road test data, to obtain the historical road test data, where the target historical time period is the time period where the preset scenario is located.

Descriptions to specific functions and examples of respective units in the apparatus according to the embodiment of the present disclosure may refer to related descriptions to corresponding steps of the above method embodiments, and will not be repeated here.

In the technical solution of the present disclosure, acquisition, storage and application of a user's personal information involved are all in compliance with provisions of relevant laws and regulations, and do not violate public order and good customs.

According to an embodiment of the present disclosure, the present disclosure further provides an electronic device, a readable storage medium and a computer program product.

FIG. 10 shows a schematic block diagram of an exemplary electronic device 1000 that may be used to implement the embodiments of the present disclosure. The electronic device is intended to represent various forms of digital computers, such as a laptop, a desktop, a workstation, a personal digital assistant, a server, a blade server, a mainframe computer, and other suitable computers. The electronic device may also represent various forms of mobile devices, such as a personal digital processing, a cellular phone, a smart phone, a wearable device and other similar computing devices. The components shown herein, their connections and relationships, and their functions are merely examples, and are not intended to limit the implementation of the present disclosure described and/or required herein.

As shown in FIG. 10, the device 1000 includes a computing unit 1001 that may perform various appropriate actions and processes according to a computer program stored in a Read-Only Memory (ROM) 1002 or a computer program loaded from a storage unit 1008 into a Random Access Memory (RAM) 1003. Various programs and data required for operations of the device 1000 may also be stored in the RAM 1003. The computing unit 1001, the ROM 1002 and the RAM 1003 are connected to each other through a bus 1004. An input/output (I/O) interface 1005 is also connected to the bus 1004.

A plurality of components in the device 1000 are connected to the I/O interface 1005, and include an input unit 1006 such as a keyboard, a mouse, or the like; an output unit 1007 such as various types of displays, speakers, or the like; the storage unit 1008 such as a magnetic disk, an optical disk, or the like; and a communication unit 1009 such as a network card, a modem, a wireless communication transceiver, or the like. The communication unit 1009 allows the device 1000 to exchange information/data with other devices through a computer network such as the Internet and/or various telecommunication networks.

The computing unit 1001 may be various general-purpose and/or special-purpose processing components with processing and computing capabilities. Some examples of the computing unit 1001 include, but are not limited to, a Central Processing Unit (CPU), a Graphics Processing Unit (GPU), various dedicated Artificial Intelligence (AI) computing chips, various computing units that run machine learning model algorithms, a Digital Signal Processor (DSP), and any appropriate processors, controllers, microcontrollers, or the like. The computing unit 1001 performs various methods and processing described above, such as the method of processing simulation data for autonomous driving. For example, in some implementation, the method of processing simulation data for autonomous driving may be implemented as a computer software program tangibly contained in a computer-readable medium, such as the storage unit 1008. In some implementations, a part or all of the computer program may be loaded and/or installed on the device 1000 via the ROM 1002 and/or the communication unit 1009. When the computer program is loaded into RAM 1003 and executed by the computing unit 1001, one or more steps of the method of processing simulation data for autonomous driving described above may be performed. Alternatively, in other embodiments, the computing unit 1001 may be configured to perform the method of processing simulation data for autonomous driving by any other suitable means (e.g., by means of firmware).

Various implements of the system and technologies described above herein may be implemented in a digital electronic circuit system, an integrated circuit system, a Field Programmable Gate Array (FPGA), an Application Specific Integrated Circuit (ASIC), an Application Specific Standard Product (ASSP), a System on Chip (SOC), a Complex Programmable Logic Device (CPLD), a computer hardware, firmware, software, and/or a combination thereof. These various implementations may include being implemented in one or more computer programs, and the one or more computer programs may be executed and/or interpreted on a programmable system including at least one programmable processor. The programmable processor may be a special-purpose or general-purpose programmable processor, may receive data and instructions from a storage system, at least one input device, and at least one output device, and transmit the data and the instructions to the storage system, the at least one input device, and the at least one output device.

Program codes for implementing the method of the present disclosure may be written in any combination of one or more programming languages. The program codes may be provided to a processor or controller of a general-purpose computer, a special-purpose computer or other programmable data processing devices, which enables the program codes, when executed by the processor or controller, to cause the functions/operations specified in the flow diagram and/or block diagram to be implemented. The program codes may be completely executed on a machine, partially executed on the machine, partially executed on the machine as a separate software package and partially executed on a remote machine, or completely executed on the remote machine or a server.

In the context of the present disclosure, a machine-readable medium may be a tangible medium, which may contain or store a procedure for use by or in connection with an instruction execution system, device or apparatus. The machine-readable medium may be a machine-readable signal medium or a machine-readable storage medium. The machine-readable medium may include, but is not limited to, an electronic, magnetic, optical, electromagnetic, infrared or semiconductor system, device or apparatus, or any suitable combination thereof. More specific examples of the machine-readable storage medium may include electrical connections based on one or more lines, a portable computer disk, a hard disk, a Random Access Memory (RAM), a Read-Only Memory (ROM), an Erasable Programmable Read-Only Memory (EPROM or a flash memory), an optical fiber, a portable Compact Disc Read-Only Memory (CD-ROM), an optical storage device, a magnetic storage device, or any suitable combination thereof.

In order to provide interaction with a user, the system and technologies described herein may be implemented on a computer that has: a display apparatus (e.g., a cathode ray tube (CRT) or a Liquid Crystal Display (LCD) monitor) for displaying information to a user; and a keyboard and a pointing device (e.g., a mouse or a trackball) through which the user may provide input to the computer. Other types of apparatuses may also be used to provide interaction with the user. For example, feedback provided to the user may be any form of sensory feedback (e.g., visual feedback, auditory feedback, or tactile feedback), and the input from the user may be received in any form (including an acoustic input, a voice input, or a tactile input).

The system and technologies described herein may be implemented in a computing system including a back-end component (which serves as, for example, a data server), or in a computing system including a middleware component (which serves as, for example, an application server), or in a computing system including a front-end component (e.g., a user computer with a graphical user interface or a web browser through which the user may interact with the implementation of the system and technologies described herein), or in a computing system including any combination of the back-end component, the middleware component, or the front-end component. Components of the system may be connected to each other through digital data communication in any form or medium (e.g., a communication network). Examples of the communication network include a Local Area Network (LAN), a Wide Area Network (WAN), and the Internet.

A computer system may include a client and a server. The client and the server are generally far away from each other and usually interact with each other through the communication network. A relationship between the client and the server is generated by computer programs running on corresponding computers and having a client-server relationship with each other. The server may be a cloud server, a distributed system server, or a blockchain server.

It should be understood that, steps may be reordered, added or removed by using various forms of the flows described above. For example, respective steps recorded in the present disclosure may be performed in parallel, in sequence, or in different orders, as long as a desired result of the technical solution disclosed in the present disclosure can be realized, which is not limited herein.

The foregoing specific implementations do not constitute a limitation on the protection scope of the present disclosure. Those having skill in the art should understand that, various modifications, combinations, sub-combinations and substitutions may be made according to a design requirement and other factors. Any modification, equivalent replacement, improvement or the like made within the principle of the present disclosure shall be included in the protection scope of the present disclosure.

## Claims

1. A method of processing simulation data for autonomous driving, comprising:
obtaining (S101, S301), by a simulation device, historical road test data, wherein the historical road test data comprises original data for a same target historical time period uploaded by each data unit of N data units of a road test vehicle;
parsing (S102, S302) an i-th channel of original data in the historical road test data to obtain parsed data that matches a preset data format of a data unit of the i-th channel of original data, i is a positive integer not greater than N;
after determining that all N channels of original data have been parsed, performing (S103) downsampling processing on each channel of parsed data to obtain initial sampling data corresponding to each channel;
adjusting (S104, S305) a data frequency of the initial sampling data corresponding to each channel to obtain target simulation data corresponding to each channel; and
sending (S105, S306) the target simulation data corresponding to each channel to an autonomous driving controller for simulation.

2. The method of claim 1, further comprising:
after obtaining an i-th channel of parsed data, loading (S303) the i-th channel of parsed data into a memory,
wherein performing the downsampling processing on each channel of parsed data to obtain the initial sampling data corresponding to each channel comprises:
after determining each channel of parsed data at a specific time point is loaded to the memory, performing (S304) the downsampling processing on each channel of parsed data to obtain the initial sampling data corresponding to each channel;
wherein the specified time point is related to the target historical time period.

3. The method of claim 2, wherein the specified time point is a starting time point of the target historical time period.

4. The method of any one of claims 1 to 3, wherein performing the downsampling processing on each channel of parsed data to obtain the initial sampling data corresponding to each channel comprises:
determining a downsampling ratio corresponding to each channel; and
performing the downsampling processing on each channel of parsed data based on the downsampling ratio corresponding to each channel to obtain the initial sampling data corresponding to each channel.

5. The method of claim 4, wherein the downsampling ratio corresponding to each channel is determined based on at least one of:
a data acquisition frequency of a data unit of a current channel;
a scenario characteristic of the historical road test data; or
a degree of influence of data uploaded by the data unit of the current channel on an autonomous driving decision.

6. The method of any one of claims 3 to 5, wherein adjusting the data frequency of the initial sampling data corresponding to each channel to obtain the target simulation data corresponding to each channel comprises:
adjusting the data frequency of the initial sampling data corresponding to each channel by a manner of modifying a timestamp, to make a frame rate in unit time of the initial sampling data corresponding to each channel match with a frame rate in unit time of the original data corresponding to each channel.

7. The method of any one of claims 1 to 6, wherein transmission resources required for occupation by the original data uploaded by each data unit are less than transmission resources required for occupation by the parsed data corresponding to each data unit;
wherein the original data uploaded by each data unit is data in a binary format.

8. The method of claim 7, wherein parsing the i-th channel of original data in the historical road test data comprises:
parsing the i-th channel of original data by using a data format protocol of the data unit corresponding to the i-th channel.

9. The method of claim 1, further comprising:
generating, by the simulation device, a time modification request based on the target historical time period of the historical road test data; and
sending, by the simulation device, the time modification request to the autonomous driving controller, wherein the time modification request is configured to request the autonomous driving controller to modify current time information to a historical time point that matches with the target historical time period.

10. The method of claim 1 or 9, wherein the simulation device is provided with a board, and the board is provided with an interface adapted to each channel, and
sending the target simulation data corresponding to each channel to the autonomous driving controller for simulation comprises:
transmitting the target simulation data corresponding to each channel to the board, to send the target simulation data corresponding to each channel to the autonomous driving controller through the interface adapted to each channel provided in the board.

11. The method of claim 10, wherein the board is further provided with a master clock, and the method further comprises:
periodically sending a time synchronization message to the autonomous driving controller through the master clock, wherein the time synchronization message carries timestamp information of the master clock, so that the autonomous driving controller is able to perform time synchronization processing on a plurality of channels of target simulation data that is received based on the timestamp information.

12. The method of claim 1, further comprising:
obtaining original road test data, the original road test data comprises original data for a same first historical time period uploaded by each data unit of the N data units, and the first historical time period comprises the target historical time period; and
performing scenario recognition on the original road test data to identify the historical road test data that satisfies a preset scenario requirement.

13. The method of claim 12, wherein performing the scenario recognition on the original road test data to identify the historical road test data that satisfies the preset scenario requirement comprises:
performing the scenario recognition on the original road test data to identify a time period where a preset scenario is located; and
extracting data of the time period where the preset scenario is located from each channel of original data for the same first historical time period included in the original road test data, to obtain the historical road test data, wherein the target historical time period is the time period where the preset scenario is located.

14. A simulation device, comprising:
an obtaining unit configured to obtain historical road test data, wherein the historical road test data comprises original data for a same target historical time period uploaded by each data unit of N data units of a road test vehicle;
a processing unit configured to: parse an i-th channel of original data in the historical road test data to obtain parsed data that matches a preset data format of a data unit of the i-th channel of original data, after determining that all N channels of original data have been parsed, perform downsampling processing on each channel of parsed data to obtain initial sampling data corresponding to each channel, adjust a data frequency of the initial sampling data corresponding to each channel to obtain target simulation data corresponding to each channel, and send the target simulation data corresponding to each channel to an autonomous driving controller for simulation, i is a positive integer not greater than N.

15. A computer program product comprising a computer program, wherein the computer program, when executed by a processor, implements the method of any one of claims 1 to 13.
